**Europäisches Patentamt**

**European Patent Office**

**Office européen des brevets**

(19)

(11) Veröffentlichungsnummer : **0 372 179 B1**

(12)

# EUROPÄISCHE PATENTSCHRIFT

(45) Veröffentlichungstag der Patentschrift :
**22.04.92 Patentblatt 92/17**

(51) Int. Cl.⁵ : **H01J 37/32**, H01G 4/42,
H01P 1/06

(21) Anmeldenummer : **89117387.4**

(22) Anmeldetag : **20.09.89**

(54) Durchführrung zum Aufbringen von HF-Energie sowie deren Verwendung.

(30) Priorität : **07.11.88 CH 4122/88**

(43) Veröffentlichungstag der Anmeldung :
**13.06.90 Patentblatt 90/24**

(45) Bekanntmachung des Hinweises auf die
Patenterteilung :
**22.04.92 Patentblatt 92/17**

(84) Benannte Vertragsstaaten :
**AT BE CH DE ES FR GB GR IT LI LU NL SE**

(56) Entgegenhaltungen :
FR-A- 852 026
FR-A- 1 191 485
US-A- 2 572 970
US-A- 2 602 118
US-A- 3 013 225
US-A- 4 526 644

(73) Patentinhaber : **BALZERS
AKTIENGESELLSCHAFT
FL-9496 Balzers (LI)**

(72) Erfinder : **Wellerdieck, Klaus, Dr.
Turnhallenstrasse 9
CH-9470 Buchs (CH)**

(74) Vertreter : **Troesch, Jacques J., Dr. sc. nat. et
al
Troesch Scheidegger Werner AG
Siewerdtstrasse 95
CH-8050 Zürich (CH)**

EP 0 372 179 B1

## Beschreibung

Die vorliegende Erfindung betrifft eine gasdichte Bearbeitungskammer, insbesondere eine Vakuumkammer, mit einer Durchführung zum Aufbringen von HF-Energie durch die Wandung der Kammer auf einen drehbaren, mindestens teilweise elektrisch leitenden Träger für mindestens ein zu behandelndes Werkstück sowie deren Verwendung.

Es sind verschiedene Bearbeitungsverfahren bekannt, worin ein zu behandelndes Werkstück in eine gegen die Atmosphäre gasdichte Bearbeitungskammer eingebracht wird und dabei, um gleichmässig je nach dem betrachteten Behandlungsprozess bearbeitet zu werden, in der Kammer, durch Drehen eines Werkstückträgers bewegt wird. Insbesondere ist ein solches Vorgehen bei Vakuumbehandlungsprozessen in einer Vakuumkammer bekannt, bei denen, mindestens als Teilbehandlungsprozess, ein Hochfrequenz-Gasentladungs-Prozess mitwirkt, wie z.B. ein Hochfrequenz-Ionenätz-Prozess, ein Hochfrequenz-Zerstäubungs- oder ein HF-Substrat-Bias-Prozess.

Bei solchen Prozessen bzw. Teilprozessen muss eine Durchführung vorgesehen werden, um die Hochfrequenz-Energie auf den elektrisch leitenden, drehenden Träger oder dessen elektrisch leitende Teile aufzubringen, unter Einhaltung der Bedingung der Vakuumdichtheit. Dabei ist es bekannt, die Hochfrequenz-Energie durch Schleifkontakte auf eine Lagerwelle für den Träger aufzubringen, was aber verschiedene Nachteile mit sich bringt: Wird die Welle durch die gasdichte Kammerberandung, d.h. generell deren Wandung, durchgeführt, so ist dort eine dynamische Gasdichtung, insbesondere Vakuumdichtung, vorzusehen. Der Schleifkontakt kann dann ausserhalb der Kammer angebracht werden, womit ein nie ganz zu vermeidender Abrieb die Verhältnisse innerhalb der Kammer nicht beeinträchtigt. Allerdings ist die Auslegung einer gas-, insbesondere vakuumdichten dynamischen Dichtung dann problematisch, wenn der Wellendurchmesser relativ gross ist, d.h. man ist in der Wellendimensionierung beschränkt. Wird anderseits der Schleifkontakt innerhalb der Kammer vorgesehen, d.h. unter den dort herrschenden Verhältnissen, so bewirkt der genannte Abrieb eine Kontamination der Behandlungskammer, die in vielen Fällen nicht tolerierbar ist. Ausserdem sind der elektrischen Belastung eines solchen "Vakuumkontaktes" sehr viel engere Grenzen gesetzt (Kühlung).

Grundsätzlich ist das Vorsehen von Schleifkontakten, ob innerhalb der Kammer oder ausserhalb liegend, für das Zuführen von HF-Energie problematisch, insbesondere wenn hohe Energien zu übertragen sind.

Die vorliegende Erfindung setzt sich zum Ziel, die genannten Nachteile zu beheben.

Dies wird bei einer gasdickten Kammer der obengenannten Gattung nach dem Wortlaut des kennzeichnenden Teils von Anspruch 1 erreicht.

Grundsätzlich erfolgt die HF-Uebertragung mithin kapazitiv zwischen bezüglich der Kammerwandung ruhenden Teilen und mit dem Träger drehbewegten Teilen. Gerade wegen der in der Kammer in den meisten Fällen klar definierten Gasverhältnisse wird dabei vorzugsweise die Uebertragungskapazitätsanordnung innerhalb der Kammer vorgesehen, denn dort ist die Ueberschlagfestigkeit klar definiert, und ist, insbesondere im Vakuum, wesentlich besser als ausserhalb der Kammer.

Obwohl es durchaus möglich ist, an der Lagerwelle für den Träger, beispielsweise radial auskragend, Flansche als Kapazitätsgegenelektroden vorzusehen, die, elektrisch isoliert, entlang entsprechender, ortsfester Auskragungen laufen, wird bevorzugterweise, und nach Wortlaut von Anspruch 2, die Drehkapazität als Zylinderkondensator ausgebildet. Dies hat den Vorteil, dass die relative axiale Positionierung der Welle bezüglich der ortsfesten Elektrode beim Zylinderkondensator wesentlich unproblematischer ist als bei der oben erwähnten Plattenkondensatorstruktur, indem axiale Positionstoleranzen nur wenig Einfluss auf den Kapazitätswert nehmen, im Unterschied zu obgenanntem Plattenkondensator. Damit ist auch eine einfache Montierbarkeit und Demontierbarkeit axial gegeben, ohne dass die Kondensatorelektroden, die in der Regel wegen des benötigten Kapazitätswertes in verschachtelter Bauweise ausgeführt werden und vorzugsweise aus einem Stück gefräst sind, dazu zerlegt werden müssten.

Bevorzugterweise werden im weiteren Dichtungsverhältnisse gemäss Wortlaut von Anspruch 3 vorgesehen.

Dabei ist es in vielen Fällen erwünscht, durch vorzusehende dynamische Dichtungen bezüglich des Trägerwellendurchmessers nicht beschränkt zu sein. Das Vorgehen gemäss Anspruch 3, bei welchem die Gasdichtheit bzw. Vakuumdichtheit an der äusseren stationären Umrandung der Kammer, generell gesprochen deren Wandung, realisiert wird, ermöglicht es, wenn überhaupt notwendig, so doch nur kleindurchmessrige, dynamische Dichtungen in der Wandung vorzusehen, auch wenn die Welle in wesentlichen Abschnitten innerhalb der Kammer einen grösseren Durchmesser aufweist.

Gemäss Anspruch 4 wird weiter vorgeschlagen, die Welle vollständig in der Kammer anzuordnen, also auch ihr dem Träger abgekehrtes Ende, wobei unter "Kammer" generell alle Raumpartien verstanden seien, in welchen die für die Bearbeitung vorgesehenen Gasbedingungen herrschen. Dann kann mittels einer ebenfalls wesentlich kleiner als der Wellendurchmesser dimensionierten dynamischen Dichtung, z.B. ein Ritzel durch die Aussenwandung der Kammer geführt sein und so z.B. auf einen Zahnkranz an der Welle zu deren Drehantrieb eingegriffen werden. Die Dichtungsverhältnisse werden ganz besonders einfach, wenn die Kammer, insbesondere im Bereich der Durchführung durch die Wandung, nicht nur vakuumdicht, sondern nur statisch vakuumdicht verschlossen ist, indem beispielsweise die Welle vollständig in der Kammer liegt und mittels eines berührungslosen Antriebes, wie eines Magnetantriebes, durch die statisch gedichtete Wandung auf die Trägerwelle eingewirkt wird.

Bevorzugterweise wird laut Wortlaut von Anspruch 5 die Welle als Hohlwelle ausgebildet. Dies hat folgende Vorteile: Bei vielen Bearbeitungsprozessen, wie bei der HF-Zerstäubung oder einem HF-Substrat-Bias-Prozess, ist es erwünscht, den Bearbeitungsprozess in der Kammer zu überwachen, oder, in anderen Fällen, kann es erwünscht sein, den Bearbeitungsprozess zusätzlich zu beeinflussen, generell, es besteht das Bedürfnis, in der Kammer Signalgeber und/oder -nehmer anzuordnen, wobei hierzu das Zentrum des drehbaren Werkstückträgers ein besonders günstiger Ort in der Kammer ist.

Da nun erfindungsgemäss und grundsätzlich, um eine möglichst grosse Kopplungskapazität für die HF-Energie zu schaffen, das Bestreben besteht, den Wellendurchmesser möglichst gross zu machen, und die Dichtungsprobleme, sei dies statisch oder dynamisch, unabhängig vom Wellendurchmesser wie erwähnt leicht gelöst werden können, kann, wenn die Welle als Hohlwelle ausgebildet ist, gemäss Anspruch 6 innerhalb oder an dieser Hohlwelle ein entsprechendes Gerät montiert werden, und es können Leitungen, wie für die Speisung, Abgriffsignale etc., ebenfalls durch die Welle durchgeführt werden.

Dabei ist zu bedenken, dass die Welle dreht und dass die Hohlwelle, die prinzipiell das elegante Anordnen von Zusatzgeräten ermöglicht, bevorzugterweise auch hier, vollständig in der Kammer angeordnet ist. Ist somit gemäss Anspruch 7 die Hohlwelle rohrförmig und liegt vollständig in der Kammer, also mit ihren bei den Enden, so ist die Möglichkeit geschaffen, bevorzugterweise von der Wandung her und mit letzterer ortsfest verbunden, einen Trägerarm und/oder direkt ein Gerät in der Hohlwelle vorzusehen. Leitungen hierfür werden im oder am ortsfesten Arm geführt. Es werden dabei keine zusätzlichen dynamischen Dichtungen erforderlich, abgesehen von allenfalls für den Antrieb vorzusehenden oder separaten, kleineren dynamischen Dichtungen der Geräte. Auch wenn der Trägerarm selber als Hohlrohr ausgebildet wird, um z.B. eine Sonde mit ihren Zuführungen in die Kammer zu bringen, so genügt auch hier eine statische Dichtung, um die Kammer gegen die Umgebung zu dichten.

Anstelle eines Gerätes der genannten Art kann auch am erwähnten ortsfesten Hohlrohr ein Schauglas angebracht werden, für optische Registrierungen.

Im weiteren wird angestrebt, dass, aus Gründen entstehender Streukapazitäten zwischen der Durchführung und der üblicherweise auf Masse liegenden Kammerwandung und wegen der Leitungsinduktivitäten, die Zuführungslänge zur stationären Drehkapazitätselektrode möglichst kurz ist. Deshalb wird vorgeschlagen, hierfür auch den kürzest möglichen Weg zu wählen, gemäss Wortlaut von Anspruch 8.

Bei manchen der erwähnten Bearbeitungsprozesse ist es weiter erwünscht, das elektrische Potential des Werkstückträgers mindestens von Zeit zu Zeit zu messen, so insbesondere bei Hochfrequenz-Ionenätzen, wo das am Träger entstehende DC-Potential aussagekräftig z.B. für Stabilität bzw. Instabilität der Gasentladung ist.

Deshalb wird gemäss Wortlaut von Anspruch 9 vorgeschlagen, eine Vorrichtung zum Herausführen des elektrischen Trägerpotentials vorzusehen, vorzugsweise mit einem der Welle zuführbaren Abgreifkontakt. Dies insbesondere, um einen permanenten Reibkontakt an der drehenden Welle zu vermeiden. Bevorzugterweise wird ein der Welle manuell oder getrieben zuführbarer Kontakt vorgesehen, um in grösseren oder kleineren Zeitabständen insbesondere das erwähnte DC-Potential zu überwachen.

Die Erfindung wird anschliessend beispielsweise anhand von Figuren erläutert.

Es zeigen:

Fig. 1 schematisch einen Ausschnitt aus einer Vakuumkammer mit einem kalottenförmigen Werkstückträger und einer erfindungsgemässen Durchführung für HF-Energie in einer ersten Ausführungsvariante,

Fig. 2 anhand einer Darstellung analog zu Fig. 1 eine zweite Ausführungsvariante der Durchführung mit bevorzugter Elektrodenanordnung,

Fig. 3a bis 3c drei verschiedene Antriebsarten für einen Träger an einer erfindungsgemässen Durchführung, wobei die schematisch in Fig. 3b und 3c dargestellten Ausführungsvarianten derzeit bevorzugt werden, da sie einen freien Durchgriff für einen Transportarm durch die Hohlwelle ermöglichen,

Fig. 4 schematisch eine weitere, bevorzugte Ausführungsvariante der erfindungsgemässen Drehdurchführung mit Instrumententragarm und elektrischem Abgriff für den Träger.

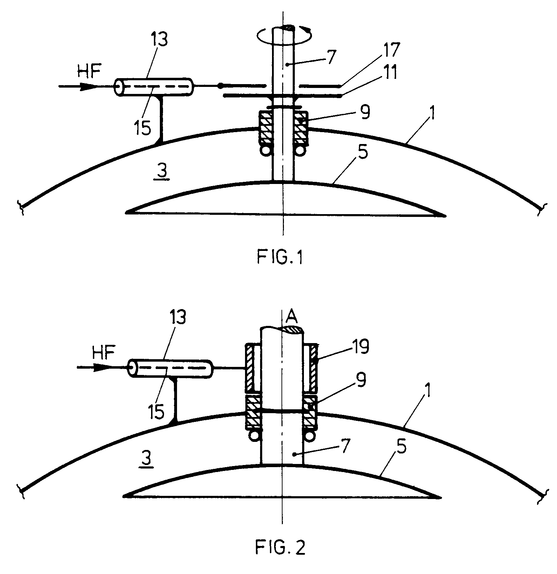

In Fig. 1 ist ein Ausschnitt einer Kammerwandung 1 dargestellt, die eine Kammer 3 gegen die Umgebung begrenzt. In der Kammer 3 wird ein (nicht dargestelltes) Werkstück unter von der Atmosphäre abweichenden Gasbedingungen bearbeitet, insbesondere, bei Vakuumprozessen, unter Vakuum. Das Werkstück ist an einem hier kalottenförmig dargestellten Werkstückträger 5 aufgehängt und wird von unten, beispielsweise durch Hochfrequenz-Ionenätzen oder HF-Ionenzerstäubung, behandelt. Der Werkstückträger 5 ist an einer Welle 7 bezüglich der Kammerwandung 1 drehbeweglich und dynamisch dicht gelagert, dabei von der Wandung 1 elektrisch isoliert, wie schematisch durch das isolierte und dichte Radial/Axiallager 9 dargestellt ist. An der Welle 7 ist erfindungsgemäss ein Bereich, gemäss Fig. 1 ein radial vorspringender leitender Kragen 11, angebracht und galvanisch mit der elektrisch leitenden Welle 7 sowie dem Träger 5 verbunden.

Ortsfest bezüglich der Wandung 1 ist eine HF-Zuführung 15 vorgesehen, schematisch dargestellt durch einen Koaxialleiter, dessen Aussenleiter 13 mit der Wandung 1 verbunden ist. Die Zuführung 15 ist mit einer leitenden Kreisringplatte 17 galvanisch verbunden, die im unmittelbaren Bereich des Kragens 11 angeordnet ist. Damit wird zwischen Kreisringplatte 17 und Kragen 11 eine Drehkapazität gebildet, deren Wert bei der Wellendrehung mindestens im wesentlichen, d.h. abgesehen von allenfalls durch die Lagerung der Welle bedingtem, unrundem Lauf, konstant ist.

Die Hochfrequenz-Energie wird über die Zuführung 15 und die Drehkapazität 11, 17 auf die sich drehende Welle 7 und damit den Werkstückträger 5 übertragen. Der Rückfluss des Hochfrequenzstromes erfolgt kapazitiv vom Träger 5 auf die üblicherweise geerdete Wandung 1 der Kammer 3 und durch die Entladung selbst.

Wie aus Fig. 1 ersichtlich, ist der Wert der Drehkapazität wesentlich von der axialen Positionierung der Welle 7 abhängig.

In Fig. 2 ist eine vorerst bezüglich Elektrodenanordnung bevorzugte Ausführungsvariante der Drehkapazität an der erfindungsgemässen Durchführung für Hochfrequenz-Energie dargestellt.

Teile, die den anhand von Fig. 1 erläuterten entsprechen, sind mit denselben Positionszeichen versehen.

Hier wird die HF-Zuführung 15 auf einen koaxial zur Achse A der Welle 7 angeordneten Zylinder 19 als Kapazitätselektrode geführt, so dass zwischen dem im Bereich des Zylinders 19 liegenden Abschnitt der Welle 7 und dem Zylinder 19 ein Zylinderkondensator gebildet wird. Der mechanische Aufbau eines solchen Zylinderkondensators ist weniger kritisch als derjenige des in Fig. 1 dargestellten Plattenkondensators 11, 17.

In den Fig. 1 und 2 ist die erfindungsgemäss vorgesehene Drehkapazität 11, 17 bzw. 7, 19 ausserhalb der Kammer 3 angebracht. Dies bringt das Problem mit sich, dass die Welle 7 gasdicht und insbesondere vakuumdicht dynamisch durch die Wandung 1 durchgeführt werden muss. Zudem ist bei dieser Anordnung für die erfindungsgemäss eingesetzte Drehkapazität nicht ausgenützt, dass ja gerade in der Kammer 3 klar definierte Gasverhältnisse und somit Verhältnisse bezüglich Durchschlagfestigkeit herrschen.

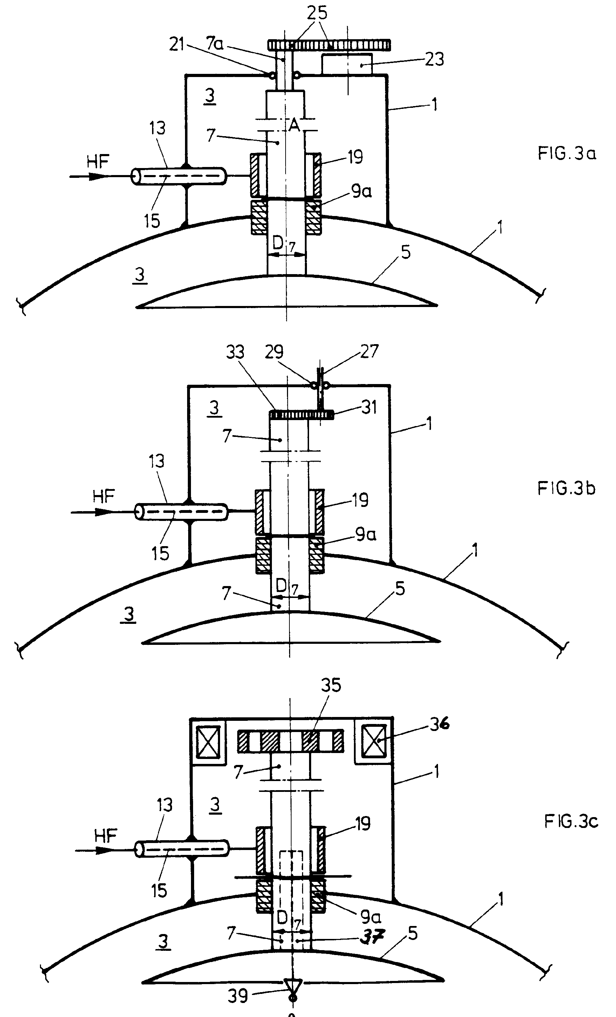

In den Fig. 3a bis 3c sind schematisch drei gegenüber den in Fig. 1 und 2 dargestellten Ausführungsvarianten vorteilhaftere Ausführungen dargestellt, wobei von diesen drei die Varianten gemäss Fig. 3b und 3c derzeit bevorzugt werden.

Es sind wiederum sich entsprechende Teile mit Bezug auf Teile in den Fig. 1 und 2 mit denselben Positionsziffern versehen.

Gemäss Fig. 3a ist das Ende der Welle 7 in ihrem Durchmesser, zur Bildung eines Antriebsachsstummels 7a, wesentlich verjüngt. Dieser Achsstummel 7a ist durch eine dynamische Gasdichtung 21, beim insbesondere betrachteten Fall einer Vakuumkammer 3, durch die Wandung 1 geführt, die im Verhältnis zum Durchmesser $D_7$ der Welle 7 klein ist. Dank dieser kleindurchmessrigen, dynamischen Vakuumdichtung 21 muss nun das gemäss Fig. 1 und 2 vorgesehene Radial/Axiallager 9 wohl weiterhin isolierend sein, jedoch nicht mehr dicht, und ist deshalb in Fig. 3 mit 9a bezeichnet. Der Bereich, in welchem die erfindungsgemäss eingesetzte Drehkapazität 19/7 liegt, gehört nun zur Kammer 3, d.h. es herrschen dort die in der Kammer eingestellten Gasverhältnisse, wie Vakuum. Der Antrieb erfolgt bei der Ausführungsvariante gemäss Fig. 3a, indem am aus der Wandung 1 der Kammer 3 herausgeführten Achsstummel 7a mittels eines Antriebsmotors 23 über eine Zahnradanordnung 25 eingegriffen wird.

In Abweichung von der in Fig. 3a dargestellten Ausführungsvariante liegt gemäss Fig. 3b die Welle 7 ganz in der Kammer 3. Der Antrieb erfolgt, indem eine in ihrem Durchmesser wesentlich kleiner als der Wellendurchmesser $D_7$ dimensionierte Ritzelwelle 27 durch die ebenso kleine dynamische Gas-, insbesondere Vakuumdichtung 29 durchgeführt ist, endständig ein Ritzel 31 trägt, welches auf einen Zahnkranz 33 an der Welle 7 eingreift.

In Fig. 3c liegt die Welle 7 wiederum vollständig in der Kammer 3. Sie trägt einen Magnetkranz 35, axial auf einen äusserhalb der Wandung 1 liegenden Kranz von Elektromagneten 36 ausgerichtet. Die Magnetanordnung 35, 36 bildet somit einen Magnetantriebsmotor oder eine Magnetkupplung für die Welle 7, wobei aber hier an der Wandung 1, für den Antrieb der Welle 7, keinerlei oder nur statische Dichtvorkehrungen vorzusehen sind.

Die Welle 7 an den bevorzugten Ausführungsbeispielen gemäss Fig. 3b oder 3c, jedoch nur in Fig. 3c eingetragen, ist bevorzugterweise als Hohlwelle ausgebildet mit einem Innenraum 37. Der Innenraum 37 ermöglicht, eine schematisch eingezeichnete Sensoranordnung und/oder Generatoranordnung 39 zu montieren, da man in der Dimensionierung des Wellendurchmessers $D_7$, insbesondere wegen des Fehlens auf diese Dimension auszulegender dynamischer Vakuumdichtungen, frei ist. Somit kann in diesem Hohlraum 37 bequem die erwähnte Anordnung 39 eingebaut werden.

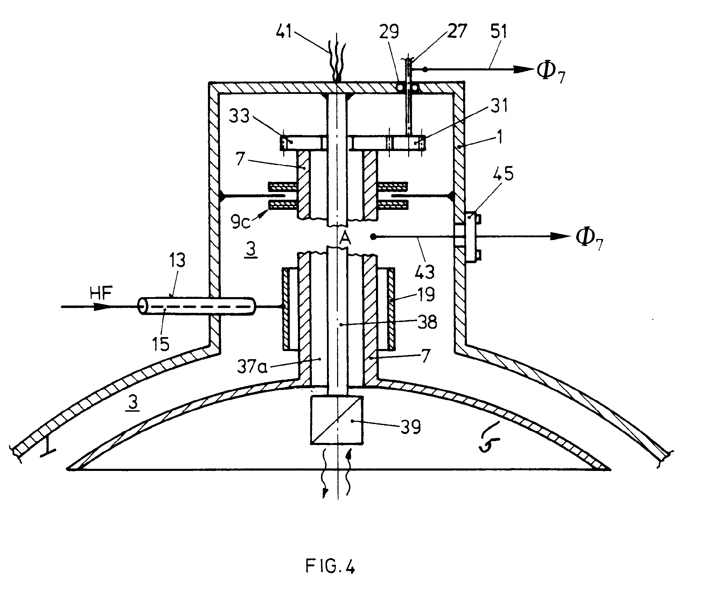

In Fig. 4 ist eine weitere, derzeit bevorzugte Ausführungsvariante der erfindungsgemässen Durchführung dargestellt. Es sind Teile, die vorgängig beschriebenen entsprechen, wiederum mit denselben Positionsziffern versehen.

Die Welle 7 ist hier oberhalb der erfindungsgemäss eingesetzten Drehkapazität 19/7 gelagert und bezüglich der Wandung 1 lediglich elektrisch isoliert, wie bei 9c dargestellt. Der Innenraum 37a der Hohlwelle 7 ist durch die ganze, als Ganzes innerhalb der Kammer 3 liegenden Welle 7 durchgeführt, wobei, fluchtend mit der Achse A der Welle 7, an der Wandung 1 ein in den Hohlraum 37a und, wie beispielsweise dargestellt, durch diesen Hohlraum 37a durchragender Instrumententrägerarm 38 angeordnet ist. Somit ist eine Signalgeber- und/oder -nehmeranordnung 39, welche am Trägerarm 38 montierbar ist, in der Kammer 3 ebenfalls ortsfest angeordnet. Zuführungen, wie Speisekabel, Signalführungskabel etc., zu der Nehmer-/Geberanordnung 39 können ohne weiteres, wie mit 41 dargestellt ist, durch den Trägerarm 38 zum entsprechenden Nehmer und-/oder Geber 39 geführt werden. Dabei wird die Geber- bzw. Nehmeranordnung 39 mit ihren Zuführungen durch den Arm 38 in sich gas-, insbesondere vakuumdicht ausgebildet. Der Arm 38 kann dabei selber Teil eines Signalgebers bzw. -nehmers sein oder als Rohr ausgebildet, ein Schauglas beinhalten, um optische Registrierungen vorzunehmen.

Obwohl in Fig. 4 der Antrieb in Analogie zur Ausführung gemäss Fig. 3b erfolgt, kann in einer Weiterausbildung der Anordnung ein Antrieb gemäss Fig. 3c vorgesehen sein.

Wie aus Fig. 4 weiter ersichtlich, wird in der Wandung 1 der Kammer 3 ein der Welle zuführbarer elektrischer Abgriff 43 vorgesehen, der in der einfachsten Ausführungsvariante und, wie schematisch bei 45 dargestellt, bezüglich der Wandung 1 dichtend und isolierend ein- und ausschraubbar ist. Durch gezieltes Zuführen des Abgriffs 43, um das elektrische Potential $\phi_7$ der Welle 7 und somit des Werkstückträgers 5 zu messen, kann man einen Schleifkontakt an der Welle 7 mit der bekannten Kontaminationsgefahr der Kammeratmosphäre vermeiden. Wird angestrebt, das elektrische Potential der Welle 7 permanent zu messen, so kann eine elektrisch leitende Verbindung über den Zahnkranz 33, Ritzel und Ritzelwelle 31, 27 nach aussen erstellt werden, die bezüglich der Wandung isoliert ist, so dass äusserhalb der Kammer das Potential hochohmig abgegriffen werden kann, wie bei 51 dargestellt. Das Herausführen des Potentials $\phi_7$ kann auch berührungslos, wie kapazitiv erfolgen.

Die beschriebene erfindungsgemässe Durchführung wird bevorzugterweise für Vakuumbearbeitungsprozesse in einer Vakuumkammer 3, insbesondere für HF-Ionenätzen und/oder HF-Bestäuben von Werkstücken und/oder HF-Substrat-Bias-Prozesse eingesetzt oder bei Prozessen, worin die genannten HF-Gasentladungsprozesse Teilprozesse bilden.


## Patentansprüche

1. Gasdichte Bearbeitungskammer, insbesondere eine Vakuumkammer, mit einer Durchführung zum Aufbringen von HF-Energie durch die Wandung der Kammer auf einen drehbaren, mindestens teilweise elektrisch leitenden Träger für mindestens ein zu behandelndes Werkstück, dadurch gekennzeichnet, dass

– der Träger (5) an einer Welle (7) drehbar bezüglich der Wandung (1) gelagert und bezüglich der Wandung elektrisch isoliert (9, 9a, 9c) ist, zur Bildung einer Drehträgeranordnung,

– an der Wandung (1) eine elektrisch isolierte HF-Zuführung (13, 15) vorgesehen ist,

– die Zuführung (13, 15) mit einer bezüglich der Wandung (1) feststehenden Elektrode (17, 19) elektrisch verbunden ist, wobei die Elektrode (17, 19) und mindestens elektrisch leitende und mit dem Träger elektrisch verbundene Teile (11, 7) der Drehanordnung als Gegenelektrode eine Kapazität bilden.

2. Gasdichte Bearbeitungskammer nach Anspruch 1, dadurch gekennzeichnet, dass die Elektrode (19) und der Teil der Drehanordnung einen Zylinderkondensator bilden, vorzugsweise in geschachtelter Bauweise.

3. Gasdichte Bearbeitungskammer nach einem der Ansprüche 1 oder 2, dadurch gekennzeichnet, dass die Kammer (3) an ihrer äusseren Berandung gasdicht, insbesondere vakuumdicht verschlossen ist.

4. Gasdichte Bearbeitungskammer nach einem der Ansprüche 1 bis 3, dadurch gekennzeichnet, dass die Welle (7) vollständig innerhalb der Kammer (3) liegt.

5. Gasdichte Bearbeitungskammer nach einem der Ansprüche 1 bis 4, dadurch gekennzeichnet, dass die Welle (7) eine Hohlwelle ist.

6. Gasdichte Bearbeitungskammer nach Anspruch 5, dadurch gekennzeichnet, dass in der Hohlwelle ein Träger für einen Signalgeber oder -nehmer oder ein Schauglas vorgesehen ist, oder ein -geber oder -nehmer selber oder ein Schauglas selber.

7. Gasdichte Bearbeitungskammer nach Anspruch 6, dadurch gekennzeichnet, dass die Hohlwelle rohrförmig ausgebildet und vollständig in der Kammer (3) angeordnet ist und ein Träger für einen Signalgeber oder -nehmer oder ein Schauglas oder der -geber oder -nehmer selber bezüglich der Wandung (1) fest und innerhalb der Hohlwelle, vorzugsweise koaxial zur Hohlwelle, angeordnet ist.

8. Gasdichte Bearbeitungskammer nach einem der Ansprüche 1 bis 7, dadurch gekennzeichnet, dass die Zuführung (13, 15) für die HF-Energie radial bezüglich der Wellenachse (A) angeordnet ist.

9. Gasdichte Bearbeitungskammer nach einem der Ansprüche 1 bis 8, dadurch gekennzeichnet, dass eine Vorrichtung (51, 43, 45) zum Herausführen des elektrischen Trägerpotentials ($\phi_7$) vorgesehen ist, vorzugsweise ein der Welle (7) zuführbarer Abgreifkontakt (43).

10. Verwendung der gasdichten Bearbeitungskammer nach einem der Ansprüche 1 bis 9, für Vakuumbehandlungsprozesse mindestens mit Hochfrequenz-Gasentladungs-Teilprozess, wie mit Ionenätz-, HF-Zerstäubungs- oder mit HF-Substrat-Bias-Prozess.

11. Gasdichte Bearbeitungskammer nach einem der Ansprüche 1 bis 9, dadurch gekennzeichnet, dass die Teile durch Teile der Wellenoberfläche gebildet sind.

12. Vakummbehandlungsanlage dadurch gekennzeichnet, dass sie eine gasdichte Bearbeitungskammer nach mindestens einem der Ansprüche 1 bis 9, 11 aufweist.


## Claims

1. A gas-tight processing chamber, in particular a vacuum chamber, having a feed-through for applying Rf-energy through the wall of the chamber on to a rotatable, at least partially electrically conductive carrier for at least one workpiece to be treated, characterized in that
– the carrier (5) is mounted on a shaft (7) rotatably with respect to the wall (1) and is electrically insulated (9, 9a, 9c) with respect to the wall, to form a rotary carrier arrangement,
– provided on the wall (1) is an electrically insulated Rf-feed means (13, 15), and
– the feed means (13, 15) is electrically connected to an electrode (17, 19) which is stationary with respect to the wall (1), whereby the electrode (17, 19) and at least electrically conductive parts (11, 7) of the rotary arrangement, which are electrically connected to the carrier, as a counterpart electrode, form a capacitor.

2. A gas-tight processing chamber according to claim 1, characterized in that the electrode (19) and the part of the rotary arrangement form a cylinder capacitor, preferably of a stacked configuration.

3. A gas-tight processing chamber according to one of claims 1 and 2, characterized in that the chamber (3) is gas-tightly and in particular vacuum-tightly closed at its outer edge.

4. A gas-tight processing chamber according to one of claims 1 to 3, characterized in that the shaft (7) is disposed completely within the chamber (3).

5. A gas-tight processing chamber according to one of claims 1 to 4, characterized in that the shaft (7) is a hollow shaft.

6. A gas-tight processing chamber according to claim 5, characterized in that provided in the hollow shaft is a carrier for a signal transmitter or receiver or a looking glass, or a signal transmitter or receiver itself or a looking glass itself.

7. A gas-tight processing chamber according to claim 6, characterized in that the hollow shaft is tubular and is arranged completely within the chamber (3) and a carrier for a signal transmitter or receiver or a looking glass or the signal transmitter or receiver itself is arranged fixedly with respect to the wall (1) and within the hollow shaft, preferably coaxially with respect to the hollow shaft.

8. A gas-tight processing chamber according to one of claims 1 to 7, characterized in that the feed means (13, 15) for the Rf-energy is arranged radially with respect to the shaft axis (A).

9. A gas-tight processing chamber according to one of claims 1 to 8, characterized in that there is provided a device (43, 45) for tapping off the electrical carrier potential ($\phi_7$), preferably a pick-up contact (43) which can be fed on the part.

10. Use of the gas-tight processing chamber according to one of claims 1 to 9 for vacuum treatment processes at least with a high frequency gas discharge process part as with an ion etching, Rf-sputtering or Rf-substrate-bias process.

11. A gas-tight processing chamber according to one of claims 1 to 9, characterized in that the parts are formed by parts of the shaft surface.

12. A vacuum treatment installation, characterized in that it has a gas-tight processing chamber according to at least one of claims 1 to 9 and 11.

EP 0 372 179 B1

**Revendications**

1. Chambre d'usinage étanche aux gaz, notamment chambre sous vide, comportant un passage pour appliquer de l'énergie à haute fréquence, à travers la paroi de la chambre, à un support rotatif au moins en partie électriquement conducteur prévu pour une ou plusieurs pièces à traiter, caractérisée en ce que
 – le support (5) est monté sur un arbre (7), rotatif par rapport à la paroi (1), et est isolé électriquement (9, 9a, 9c) par rapport à la paroi, pour former un dispositif de support rotatif,
 – une conduite d'alimentation à haute fréquence (13, 15) isolée électriquement est prévue sur la paroi (1), et
 – la conduite d'alimentation (13, 15) est reliée électriquement à une électrode (17, 19) fixe par rapport à la paroi (1), l'électrode (17, 19) et au moins des éléments (11, 7) du dispositif rotatif électriquement conducteurs et reliés électriquement au support et servant de contre-électrode, formant une capacité.

2. Chambre d'usinage étanche aux gaz selon la revendication 1, caractérisée en ce que l'électrode (19) et l'élément du dispositif rotatif forment un condensateur cylindrique, à structure de préférence emboîtée.

3. Chambre d'usinage étanche aux gaz selon l'une des revendications 1 et 2, caractérisée en ce que la chambre (3) est fermée de façon étanche aux gaz, notamment étanche au vide, au niveau de sa bordure extérieure.

4. Chambre d'usinage étanche aux gaz selon d'une des revendications 1 à 3, caractérisée en ce que l'arbre (7) se trouve entièrement à l'intérieur de la chambre (3).

5. Chambre d'usinage étanche aux gaz selon l'une des revendications 1 à 4, caractérisée en ce que l'arbre (7) est un arbre creux.

6. Chambre d'usinage étanche aux gaz selon la revendication 5, caractérisée en ce qu'il est prévu, dans l'arbre creux, un support pour un émetteur ou un récepteur de signaux ou pour un verre indicateur, ou un émetteur ou un récepteur de signaux ou un verre indicateur.

7. Chambre d'usinage étanche aux gaz selon la revendication 6, caractérisée en ce que l'arbre creux a une forme tubulaire et est entièrement disposé dans la chambre (3), et un support pour un émetteur ou un récepteur de signaux ou pour un verre indicateur, ou l'émetteur ou le récepteur de signaux eux-mêmes sont disposés, fixes par rapport à la paroi (1), à l'intérieur de l'arbre creux, de préférence coaxialement à l'arbre creux.

8. Chambre d'usinage étanche aux gaz selon l'une des revendications 1 à 7, caractérisée en ce que la conduite d'alimentation (13, 15) pour l'énergie à haute fréquence est disposée radialement par rapport à l'axe (A) de l'arbre.

9. Chambre d'usinage étanche aux gaz selon l'une des revendications 1 à 8, caractérisée en ce qu'il est prévu un dispositif (51, 43, 45) pour prélever le potentiel électrique du support ($\phi_7$) de préférence sous la forme d'un contact de prélèvement (43) apte à être amené à l'élément.

10. Utilisation de la chambre d'usinage étanche aux gaz selon l'une des revendications 1 à 9, pour des procédés de traitement sous vide comportant au moins un procédé partiel de décharge gazeuse à haute fréquence tel qu'un procédé d'érosion ionique, de pulvérisation à haute fréquence ou de polarisation de substrat à haute fréquence.

11. Chambre d'usinage étanche aux gaz selon l'une des revendications 1 à 9, caractérisée en ce que les éléments sont définis par des parties de la surface de l'arbre.

12. Installation de traitement sous vide, caractérisée en ce qu'elle comporte une chambre d'usinage étanche aux gaz selon l'une au moins des revendications 1 à 9, 11.

FIG.1

FIG. 2

FIG.3a

FIG.3b

FIG.3c

FIG. 4